# EUROPÄISCHE PATENTSCHRIFT

(11) **EP 1 060 300 B1**
(45) Veröffentlichungstag und Bekanntmachung des Hinweises auf die Patenterteilung: **11.09.2002**
(21) Anmeldenummer: 99919032.5
(22) Anmeldetag: 25.02.1999
(51) Int. Cl.: C30B 1/00

(54) **ABO3- PEROWSKIT MIT STUFE**
ABO3 PEROVSKITE WITH A STEP
PEROVSKITE DE TYPE ABO3 A GRADIN

(30) Priorität: 03.03.1998 DE 19808778
(43) Veröffentlichungstag der Anmeldung: 20.12.2000
(73) Patentinhaber: Forschungszentrum Jülich GmbH, 52425 Jülich (DE)
(72) Erfinder: SPEIER, Wolfgang, D-52428 Jülich (DE); SZOT, Kristof, D-52428 Jülich (DE)
(86) Internationale Anmeldenummer: DE9900587
(87) Internationale Veröffentlichungsnummer: WO99045180

(56) Entgegenhaltungen:
- EP-A- 0 493 258
- EP-A- 0 545 815
- EP-A- 0 545 816
- EP-A- 0 572 324
- EP-A- 0 573 340
- EP-A- 0 655 789
- EP-A- 0 660 428
- EP-A- 0 674 349
- US-A- 5 612 545
- PATENT ABSTRACTS OF JAPAN vol. 012, no. 162 (E-609), 17. Mai 1988 (1988-05-17) -& JP 62 273782 A (NIPPON TELEGR & TELEPH CORP), 27. November 1987 (1987-11-27)
- PATENT ABSTRACTS OF JAPAN vol. 014, no. 467 (E-0989), 11. Oktober 1990 (1990-10-11) -& JP 02 192172 A (FUJITSU LTD), 27. Juli 1990 (1990-07-27)
- TAKEUCHI I. ET AL: 'Ion milling damage and regrowth of oxide substrates studied by ion milling channeling and atomic force microscopy' APPL. PHYS. LETT. Bd. 70, Nr. 23, 09 Juli 1997, USA, Seiten 3098 - 3100

## Beschreibung

Die Erfindung bezieht sich auf ein Substrat, das aus einem einkristallinen Perowskiten vom Typ ABO₃ besteht und das eine Stufe aufweist, auf ein Herstellungsverfahren für das Substrat sowie auf eine Verwendungsweise. Es handelt sich beispielsweise um die Perowskite SrTiO₃, BaTiO₃, PbTiO₃ oder KNbO₃. Die beiden voneinander getrennten Oberflächen der Stufe, die parallel zueinander angeordnet sind, werden im folgenden Trittflächen genannt. Die Fläche, die die beiden Trittflächen voneinander trennt, wird im folgenden Stufenflanke genannt.

Es ist bekannt, einkristalline Perowskite vom Typ ABO₃ als Substrat bei einkristallinem Schichtwachstum einzusetzen. Diese werden im folgenden ABO₃-Substrate genannt. Es ist ferner aus der Druckschrift DE 196 08 564 A1 bekannt, eine Stufe in einem ABO₃-Substrat vorzusehen und begrenzt auf die Trittflächen ein supraleitendes Material aufzubringen. Es entsteht so ein Tunnelkontakt an der Stufenflanke.

Es ist bekannt, eine Stufe im ABO₃-Substrat durch Sputtern mit Argon herzustellen. Ein Teil des ABO₃-Substrates wird mit einer Maske abgedeckt. Anschließend wird mit Argon gesputtert und dabei der unbedeckte Teil abgetragen. Die Maske wird anschließend entfernt und so die Stufe hergestellt.

Nachteilhaft hat das Sputtern zur Folge, daß die chemische Zusammensetzung der so hergestellten Trittfläche verändert wird. Es entsteht eine neue Mikrostruktur, die zahlreiche Unebenheiten aufweist. Die Herstellung einer Stufe durch Ionenstrahlätzen ist den Druckschriften US 56 12 545 A sowie US-Z: Appl. Phys. Letters, Bd 65, 1994, Seiten 1177 - 1179, zu entnehmen.

Die Unebenheiten haben zur Folge, daß einkristalline Schichten nicht mehr ohne Stapelfehler aufgetragen werden können. Die elektrischen Eigenschaften der nachfolgend aufgetragenen Schichten verändern sich unerwünscht.

Um die durch Sputtern aufgetretenen Defekte zu minimieren, werden ABO₃-Substrate anschließend einer thermischen Behandlung unterzogen.

Dabei entwickelt sich, wie aus I. Takekeuchi et al.: "Ion milling damage and regrowth of oxide substrates studied by ion channeling and atomic force microscopy", Appl. Phys. Lett. 70(23) 1997 bekannt ist, aus der zunächst flachen aber defekten Oberfläche eine rauhe Oberfläche mit angedeuteten Stufen, die sich im weiteren Verlauf der Aufheizphase zu kristallographisch idealen Kristallstufen reorganisieren.

Aus der Druckschrift EP 0 674 349 A1 ist bekannt, eine Stufe der eingangs genannten Art durch ein Laser-Ätzverfahren zu erzeugen. Hierdurch sollen störungsfreie Trittstellen im Vergleich zum Ionenstrahlätzen bereitgestellt werden. Wie beim bekannten Ionenstrahlätzen wird jedoch auch hier eine Oberfläche abgetragen und somit mechanisch verändert. Eine Beibehaltung der ursprünglichen Oberflächentopographie kann durch dieses Verfahren daher ebenfalls nicht erreicht werden.

Aufgabe der Erfindung ist die Schaffung eines Verfahrens zur Herstellung eines stufenförmigen ABO₃-Substrates mit verbesserten Eigenschaften. Aufgabe der Erfindung ist ferner die Bereitstellung eines derartigen ABO₃-Substrates sowie die Angabe einer Verwendung.

Die Aufgabe der Erfindung wird durch ein Verfahren mit den Merkmalen des Hauptanspruchs sowie durch ein ABO₃-Substrat mit den Merkmalen des entsprechenden Nebenan spruchs gelöst. Eine Verwendungsweise ergibt sich aus dem Verwendungsanspruch.

Verfahrensgemäß wird ein ABO₃-Substrat, also zum Beispiel die aus einkristallinem SrTiO₃, BaTiO₃, PbTiO₃ oder KNbO₃ bestehenden Substrate, im plastischen Arbeitsbereich gebogen. Hierfür wird der Kristall zum Beispiel in eine Biegevorrichtung eingespannt und so lange gebogen, bis plastische Verformungen in Form von Stufen auftreten.

In einer vorteilhaften Ausgestaltung des Verfahrens werden Drucklinien (ein Druck entlang einer Linie) während der Biegung im ABO₃-Substrat erzeugt. Durch Erzeugen der Drucklinien kann der Abstand der entstehenden Stufen eingestellt werden. Die Drucklinien verlaufen parallel zu den späteren Kanten der Stufen.

Verfahrensgemäß entsteht ein ABO₃-Substrat mit einer treppenförmigen Oberfläche. Die Oberflächentopographien der Trittflächen werden durch das Biegen nicht verändert. Ein weiterer Vorteil dieses Verfahrens liegt in der Schaffung einer gleichmäßigeren Höhe der Stufenflanke (entlang der gesamten Länge der Stufenflanke) im Vergleich zum genannten Stand der Technik.

In einer vorteilhaften Ausgestaltung des Verfahrens wird zur Herstellung eines ABO₃-Substrat mit einer Stufe zunächst einmal eine treppenförmige Oberfläche erzeugt. (Ausgesuchte) Stufen der Treppe (die nicht von Interesse sind) werden zum Beispiel mit einer Metallmaske bedeckt. Auf diese Weise kann eine einzelne (nicht mit einer Metallmaske bedeckte) Stufe im folgenden weiter bearbeitet werden, z.B. mit einer einkristallinen Schicht bedeckt werden.

In einer vorteilhaften Ausgestaltung des Verfahrens wird ein ABO₃-Substrat mit einer (100)-Oberfläche bereitgestellt. Senkrecht zur (100)-Richtung wird der Kristall gebogen. Unter (100)-Oberfläche sind auch die (010) - sowie die (001)-Oberflächen zu verstehen.

Diese Ausgestaltung bewirkt, daß die Stufen frei von Zacken bleiben. Bei anderen Orientierungen können Zakken in der Stufe auftreten. Die Qualität der Stufe wird so also in verbesserter Weise sichergestellt.

Das anspruchsgemäße ABO₃-Substrat weist eine Stufe auf. Die Trittflächen weisen gleiche Oberflächentopographien auf. Sie sind frei von Mikrostrukturen, die Unebenheiten verursachen.

Die Stufenhöhe beträgt in der Regel 10 - 100 nm. Die Stufe kann mehrere mm breit sein.

In einer vorteilhaften Ausgestaltung der anspruchsgemäßen Vorrichtung weist das ABO₃-Substrat an einer Oberfläche eine Treppe auf. Die Trittflächen sind gleich in Bezug auf die Oberflächentopographie.

Es zeigen
- Figur 1:: SrTiO₃-Substrat mit einer (100)-Oberfläche, das eine anspruchsgemäß hergestellte Stufe aufweist,
- Figur 2:: SrTiO₃-Substrat, das eine Stufe aufweist, die durch Sputtern mit Argon hergestellt worden ist.

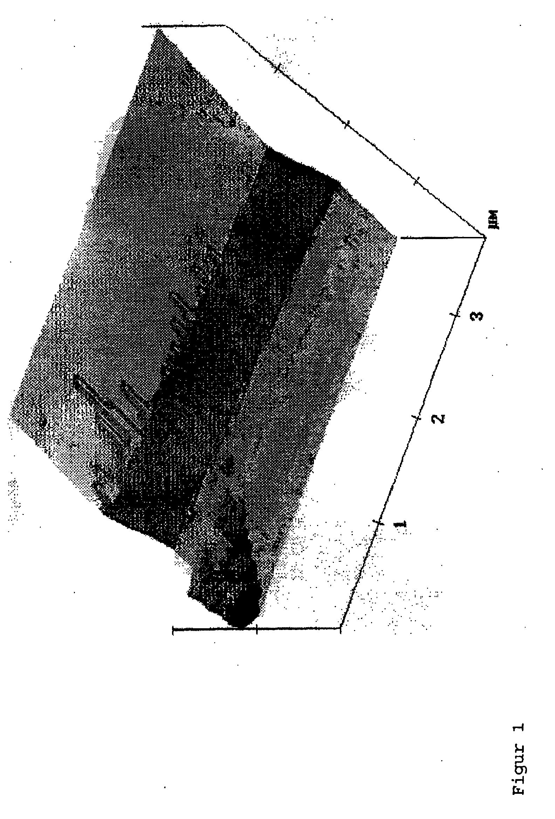

Das in Figur 1 gezeigte SrTiO₃-Substrat mit der Stufe ist mehrere mm breit und ca. 50 - 60 nm hoch. Die Trittflächen der Stufen sind identisch und weisen keine veränderten Mikrostrukturen auf.

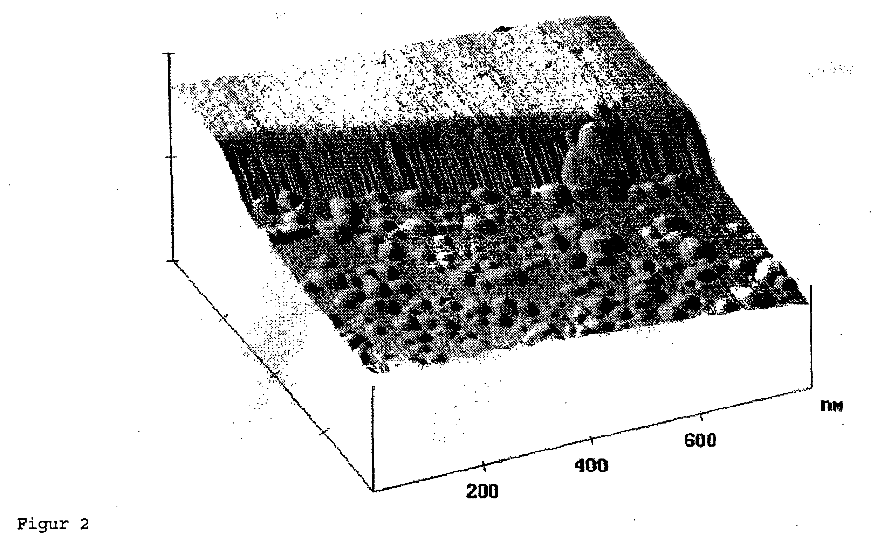

Figur 2 zeigt zum Vergleich das Ergebnis, das durch Sputtern mit Argon in der eingangs geschilderten Weise erzielt worden ist. Die untere Trittfläche weist veränderte Mikrostrukturen auf.

Beide gezeigten SrTiO₃-Substrate wurden thermisch nicht nachbehandelt. Bei dem in Figur 2 gezeigten SrTiO₃-Substrat ist regelmäßig eine thermische Nachbehandlung erforderlich, um die Fehler zu reduzieren.

Die Figuren stellen Aufnahmen dar, die mit einem Rasterkraftmikroskop erzeugt worden sind.
¹ I.e. the parallel upper faces - Translator

## Patentansprüche

1. Verfahren zur Herstellung eines ABO₃-Substrates mit einer Stufe, indem ein ABO₃-Substrat im plastischen Arbeitsbereich gebogen wird.

2. Verfahren nach vorhergehendem Anspruch, bei dem ein ABO₃-Substrat mit einer (100)-Oberfläche senkrecht zur (100)-Oberfläche im plastischen Arbeitsbereich gebogen wird.

3. Verfahren nach einem der vorhergehenden Ansprüche, **gekennzeichnet durch** Erzeugung von Drucklinien während der Biegung des ABO₃-Substrates.

4. ABO₃-Substrat mit einer Stufe, herstellbar nach einem Verfahren nach einem der vorhergehenden Ansprüche, bei der beide Trittflächen der Stufe die gleiche Topographie aufweisen, und die Stufenhöhe 10 - 100 nm beträgt.

5. ABO₃-Substrat nach vorhergehendem Anspruch 4, mit einer aus supraleitendem Material bestehenden Beschichtung der Trittflächen des ABO₃-Substrates.

6. ABO₃-Substrat nach Anspruch 4 oder 5, **gekennzeichnet durch** eine treppenförmige Oberfläche.

7. Verwendung eines ABO₃-Substrat nach einem der Ansprüche 4 bis 6, bei der beide Trittflächen der Stufe die gleiche Topographie aufweisen, für ein elektronisches Bauelement.

## Claims

1. A method for manufacturing an ABO₃ substrate with a step, **whereby** an ABO₃ substrate is bent within its plastic working range.

2. A method according to the preceding claim, **whereby** an ABO₃ substrate with a (100) surface is bent perpendicularly to the (100) surface within its plastic working range.

3. A method according to one of the preceding claims, **characterised by** the generation of lines of pressure during bending of the ABO₃ substrate.

4. An ABO₃ substrate with a step, which can be manufactured according to a method according to one of the preceding claims, **wherein** the tread¹ faces of the step have the same topography and the step height is 10 - 100 nm.

5. An ABO₃ substrate according to the preceding Claim 4, with a coating of the tread faces of the ABO₃ substrate which consists of superconductive material.

6. An ABO₃ substrate according to Claim 4 or 5, **characterised by** a step-shaped surface.

7. An application of an ABO₃ substrate according to one of the claims 4 to 6, **wherein** both tread faces of the step have the same topography, for an electronic component.

## Revendications

1. Procédé de fabrication d'un substrat en ABO₃ à gradin, dans lequel on courbe un substrat en ABO₃ dans la zone de travail plastique.

2. Procédé suivant la revendication précédente, dans lequel on courbe dans le domaine de travail plastique un substrat en ABO₃ ayant une surface (100) perpendiculairement à la surface (100).

3. Procédé suivant l'une des revendications précédentes, **caractérisé par** la production de lignes de pression pendant la courbure du substrat en ABO₃.

4. Substrat en ABO₃ à gradin pouvant être fabriqué par un procédé suivant l'une des revendications précédentes, dans lequel les deux girons du gradin ont la même topographie et la hauteur du gradin est comprise entre 10 et 100 nm.

5. Substrat en ABO₃ suivant la revendication 4 précédente, ayant un revêtement en matériau supraconducteur des girons du substrat en ABO₃.

6. Substrat en ABO₃ suivant la revendication 4 ou 5, **caractérisé par** une surface en escalier.

7. Utilisation d'un substrat en ABO₃ suivant l'une des revendications 4 à 6, dans lequel deux girons du gradin ont la même topographie, pour un composant électronique.
